(19) Europäisches Patentamt
European Patent Office
Office européen des brevets

(11) **EP 2 079 783 B1**

(12) **EUROPÄISCHE PATENTSCHRIFT**

(45) Veröffentlichungstag und Bekanntmachung des Hinweises auf die Patenterteilung:
**23.05.2012 Patentblatt 2012/21**

(21) Anmeldenummer: **07801289.5**

(22) Anmeldetag: **30.08.2007**

(51) Int Cl.:
***C23C 16/50*** (2006.01)     ***C23C 16/455*** (2006.01)
***C23C 16/30*** (2006.01)

(86) Internationale Anmeldenummer:
**PCT/DE2007/001552**

(87) Internationale Veröffentlichungsnummer:
**WO 2008/043325 (17.04.2008 Gazette 2008/16)**

(54) **PICVD -BESCHICHTUNG FÜR KUNSTSTOFFBEHÄLTER**

PICVD COATING FOR PLASTIC CONTAINERS

REVÊTEMENT DE DÉPÔT CHIMIQUE EN PHASE VAPEUR ASSISTÉ PAR PLASMA (PICVD)

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **14.10.2006 DE 102006048658**

(43) Veröffentlichungstag der Anmeldung:
**22.07.2009 Patentblatt 2009/30**

(73) Patentinhaber: **KHS Corpoplast GmbH**
**22145 Hamburg (DE)**

(72) Erfinder:
• **BEHLE, Stephan**
**55239 Gau-Odernheim (DE)**
• **WOYWOOD, Tanja**
**55131 Mainz (DE)**
• **KLEIN, Jürgen**
**55127 Mainz (DE)**
• **ROTHAAR, Uwe**
**67134 Birkenheide (DE)**

(74) Vertreter: **Klickow, Hans-Henning et al**
**Patentanwälte**
**Hansmann-Klickow-Hansmann**
**Jessenstrasse 4**
**22767 Hamburg (DE)**

(56) Entgegenhaltungen:
**EP-A- 1 388 594       EP-A- 1 630 250**
**WO-A- 02/16484       DE-A1- 10 314 779**
**DE-A1- 19 650 286**

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft einen Kunststoffbehälter und ein Verfahren zum Aufbringen einer Beschichtung auf den Kunststoffbehälter gemäß dem Oberbegriff der unabhängigen Ansprüche.

Kunststoffhohlbehälter wie etwa Plastikflaschen weisen zumeist eine für den gedachten verwendungszweck nicht ausreichende Barrierewirkung für Gase auf. Beispielsweise können Gase wie Kohlendioxid aus dem Behälter hinaus- oder in diesen hineindiffundieren. Dieser Effekt ist zumeist unerwünscht. Unter anderem führt dieser Effekt zu einer Verkürzung der Haltbarkeit von in diesen Behältern gelagerten Getränken.

Um diese Nachteile bei Kunststoffgefäßen mit ihren ansonsten vielfältigen Vorzügen zu beseitigen, sind Techniken zum Aufbringen von Barriereschichten beziehungsweise Diffusionssperrschichten entwickelt worden. Um für eine Reduktion der Permeation von Gasen und Flüssigkeiten zu sorgen sowie das Kunststoffmaterial gegen chemische Angriffe oder UV-Strahlung zu schützen, ist es vorteilhaft Substratmaterialien wie zum Beispiel dreidimensionale Hohlkörper, mit einer Barrierebeschichtung zu versehen. Durch Beschichtungen können mit kostengünstigen Massenkunststoffen dieselben Eigenschaft wie bei teuren Spezialkunststoffen erreicht und der Ersatz von beispielsweise Glas im Bereich der Pharmaverpackungen wird durch derartige Massenkunststoffe ermöglicht.

Eine besonders effektive und kostengünstige Technologie für das Aufbringen solcher Schichten ist die chemische Dampfphasenabscheidung (CVD). Bei den CVD-Verfahren geschieht die Abscheidung einer Schicht über ein reaktives chemisches Gasgemisch, welches die zu beschichtende Oberfläche umgibt. Als Diffusionsbarrieren haben sich unter anderem Oxidschichten, wie etwa $SiO_x$-Schichten bewährt.

Ein chemisch reaktives Gasgemisch kann für die CVD-Beschichtung thermisch oder durch Ionisation der Prozeßgase durch Eintrag von Energie erzeugt werden. Da Kunststoffe in der Regel thermisch nicht ausreichend stabil sind oder niedrige Erweichungspunkte aufweisen, ist für die Beschichtung von Kunstoffoberflächen die CVD-Beschichtung unter Temperatureinwirkung ungeeignet. Hier bietet sich jedoch die Möglichkeit der plasmaunterstützten CVD-Beschichtung (PECVD) an. Da auch hier durch das Plasma eine Erwärmung der zu beschichtenden Oberfläche auftritt, ist insbesondere die Plasmaimpuls-induzierte CVD-Beschichtung (PICVD) geeignet, um auf temperatursensitive Materialien wie Kunststoffe Beschichtungen aufzubringen.

Derzeitige mit PECVD aufgebrachte $SiO_x$-Barriereschichten auf Kunststoff weisen jedoch in der Regel eine geringe Laugenbestätigkeit auf. Wie Messungen zeigen, wird bereits ab pH-Werten von größer oder gleich 5 in Verbindung mit einer bestimmten Ionenkonzentration bzw. bestimmten Leitwerten einer Flüssigkeit die Barriereschicht geradezu flächig weggeätzt. Hierbei erweisen sich stille Mineralwässer und Leitungswasser für die Schichtbeständigkeit kritischer als durch Osmosefilter gepreßtes Wasser oder VE-Wasser.

Der Vorgang des Wegätzens geht umso schneller vonstatten, je höher der pH-Wert und/oder die Füll- bzw. Lagertemperatur des abgefüllten Produktes ist. Derartige Schichten haben daher den Nachteil, im Anschluß an die Lagerung einer entsprechenden Flüssigkeit in einem Kunststoffbehälter mit einer solchen Barriereschicht zwischen dem Kunststoff und der Flüssigkeit nur noch eine stark herabgesetzte Barrierewirkung der Beschichtung aufzuweisen, welche vom pH-wert und Lager- bzw. Füllbedingungen abhängt. Es kann sogar vorkommen, daß überhaupt keine Barrierewirkung mehr vorhanden ist.

Der pH-Wert von einigen Getränken, wie z.B. grünem Tee, Kaffee- und Milchprodukten, sowie insbesondere stillen oder nur schwach karbonisierten Mineralwässern liegt im Bereich zwischen 6,5 und 7,5. Hier wird, um typische Haltbarkeiten in Kunststoffverpackungen zu erreichen, eine pH-beständige Barriereschicht mit einer Haltbarkeit von 6 bis 12 Monaten bei Raumtemperatur (23˚C) gefordert.

In einigen Ländern werden bestimmte Produkte, wie grüner Tee oder Kaffee heiß, d. h. bei Temperaturen bis zu 95˚C, abgefüllt, anschließend bei Raumtemperatur bis zu sechs Monate gelagert, um dann zum Verkauf bis zu 14 Tage bei 60˚C gelagert zu werden. Es gibt auch eine Entwicklung dahingehend, diese Produkte erst kurz vor dem verzehr mittels Mikrowelle zu erhitzen. Dies kommt beispielsweise in Getränkeautomaten zum Einsatz. Auch unter diesen Bedingungen besteht die Anforderung, eine pH-beständige Barrierebeschichtung bereitzustellen.

Für pharmazeutische packmittel wird eine pH-Beständigkeit bis zu einem pH-wert von 10 für entsprechende Barriereschichten bei einer Lagerdauer bei Raumtemperatur von typischerweise drei bis fünf Jahren gefordert. Beschleunigte Tests simulieren dies mit einer Lagerung bei 60˚C über sechs Monate. Die Anforderungen für technische Packmittel zur verpackung von beispielsweise Feinchemikalien, Bremsflüssigkeit, Reinigungsmitteln usw. decken sich in etwa mit den Anforderungen an pharmazeutische Packmittel.

Aus der DE 103 14 779 A1 ist es bereits bekannt, im Bereich einer Außenseite eines Verpackungsmaterials eine Barriereschicht anzuordnen, die mit einer Schutzschicht bedeckt wird. Die Schutzschicht dient insbesondere dazu, eine direkte Einwirkung von Wasser oder Feuchtigkeit auf die Barriereschicht zu verhindern.

In der WO 02/16484 A wird ebenfalls die Anordnung einer Barriereschicht im Bereich einer Außenseite eines Behälters beschrieben. Auch hier wird die Barriereschicht mit einer äußeren Abdeckschicht versehen. Die Abdeckschicht dient dabei zum Verschließen kleiner Fehlstellen in der Barriereschicht.

Aus der EP-A-1630250 ist es bekannt, im Bereich einer Innenseite eines Behälters eine Barriereschicht anzuordnen und diese mit einer dem zu verpackenden Produkt zugewandten Schutzschicht zu versehen. zur Bereitstellung einer angestrebten Beständigkeit der Schutzschicht wird hierbei ein vorgegebener Bereich für den Kohlenstoffanteil als maßgeblich angesehen.

Es ergibt sich daher eine Aufgabe der Erfindung, Barriereschichten derart weiterzubilden, dass sie bei Kontakt mit Medien, welche einen pH-wert oberhalb von 5, insbesondere oberhalb von 6,5 aufweisen, bei Raumtemperatur mindestens sechs Monate lang ihre Barrierewirkung behalten.

Es ergibt sich eine weitere Aufgabe der Erfindung, Schichten mit Barrierewirkung zu schaffen, deren Barrierewirkung auch bei Kontakt mit Medien bis zu einem pH-Wert von 10 bei Raumtemperatur zumindest drei Jahre lang ihre Barrierewirkung behalten. Zudem ist es eine Aufgabe der Erfindung, Produkte mit einem pH-Wert im Bereich zwischen 6,5 und 7,5 bis zu 14 Tage bei einer Temperatur von 60°C in einem Kunststoffbehälter, welcher eine Barriereschicht aufweist, lagern zu können, ohne dass die Barriereschicht wesentlich geschädigt wird.

Diese Aufgaben werden auf überraschend einfache Weise mit Hilfe der Erfindung gelöst durch ein Verbundmaterial nach Anspruch 1. Des weiteren schafft die Erfindung ein verfahren zum Herstellen eines solchen Verbundmaterials.

Die Erfindung stellt ein Verbundmaterial zur Verfügung, welches ein Substrat und eine Beschichtung auf dem Substrat umfaßt. Die Beschichtung weist dabei zumindest einen dem Substrat zugewandten ersten Bereich und zumindest einen vom Substrat abgewandten zweiten Bereich auf. Der erste Bereich umfaßt eine Barriereschicht, und der zweite Bereich umfaßt eine Passivierungsschicht.

Die Passivierungsschicht ist gemäß der Erfindung vorzugsweise ein sogenanntes "top coat", das heißt die vom Substrat her gesehen letzte Schicht der Beschichtung. Durch die Passivierungsschicht wird eine Schutzschicht für die Barriereschicht gegen Angriffe, insbesondere durch Ätzen zur Verfügung gestellt. Das erfindungsgemäße Verbundmaterial hat daher eine gegenüber Materialien mit Beschichtungen ohne eine Passivierungsschicht deutlich erhöhte Lebensdauer bei wirksamer Barriere. Durch Aufbringen der Passivierungsschicht werden Bindungstypen im Vergleich zur Barriereschicht derart beeinflußt, daß die Zersetzung der Barriereschicht zumindest verzögert, in den meisten Fällen sogar im Wesentlichen vermieden wird.

Spezielle Größen, die bereits bei einem unbenutzten Verbundmaterial bestimmt werden können und mit der sich im Laufe der Nutzung zeigenden erhöhten Lebensdauer der erfindungsgemäßen Beschichtung korrelieren, wurden von den Erfindern in Form des O-Parameters und des N-Parameters gefunden. In einer vorteilhaften Ausführungsform der Erfindung weist die Passivierungsschicht einen O-Parameter

$$\text{mit } O - Parameter = \frac{\text{Intensität bei } 1253 \text{ cm}^{-1}}{\text{Intensität bei } \left(1000 \text{ cm}^{-1} \text{ bis } 1100 \text{ cm}^{-1}\right)}$$

gemessen mit ATR (attenuated total reflection) im Bereich von 0,4 bis 0,9, bevorzugt im Bereich von 0,45 bis 0,55 auf. Der Wert für die Intensität im Bereich zwischen 1000 cm$^{-1}$ und 1100 cm$^{-1}$ wird folgendermaßen ermittelt:

$$\text{Intensität bei } \left(1000 \text{ cm}^{-1} \text{ bis } 1100 \text{ cm}^{-1}\right) =$$
$$\max\left[\text{Intensität}\left(1000 \text{ cm}^{-1}\right); \text{Intensität}\left(1100 \text{ cm}^{-1}\right)\right]$$

Das bedeutet, es wird der größte Wert für die Intensität genommen, der im Bereich von 1000 cm-1 bis 1100 cm-1 auftritt. Bei welcher Wellenzahl der interessierende Peak liegt, hängt von der jeweiligen spezifischen Struktur der Probe ab.

Die Intensität wird bei den ATR-Messungen als "absorbance" in willkürlichen Einheiten (a. u.) bestimmt.

Vorteilhafterweise weist die Passivierungsschicht einen

$$N-Parameter \text{ mit } N - Parameter = \frac{\text{Intensität bei } 840 \text{ cm}^{-1}}{\text{Intensität bei } 799 \text{ cm}^{-1}}$$

gemessen mit ATR (attenuated total reflection) im Bereich von 0,7 bis 1,6, bevorzugt im Bereich von 0,83 bis 1,01 auf.

Beim Herstellen der Passivierungsschicht wird gemäß der Erfindung ein CVD, bevorzugt ein PICVD-Verfahren angewandt, wobei als Precursor silizium- oder metallorganische Verbindungen eingesetzt werden. Vorzugsweise wird HMDSO als Precursor eingesetzt, um eine unpolare organische Deckschicht als Passivierungsschicht auf einer Barrierebeschichtung zu erzeugen. Es hat sich gezeigt, daß sich die Passivierungsschicht gemäß der Erfindung gerade dann ihre vorteilhafte Wirkung aufweist, wenn bestimmte Intensitätsverhältnisse der mit SIMS gemessenen Signale für charakteristische Spezies vorliegen.

Gemäß der Erfindung weist die Passivierungsschicht des Verbundmaterials ein Intensitätsverhältnis $I_{C3/Si}$ der mit SIMS (Sekundärionen-Massenspektrometrie) gemessenen Signale für die Intensität I von $C_3$ und Si im Bereich von 2,5 bis 7. Vorteilhafterweise liegt ferner das Intensitätsverhältnis $I_{SiO_2/Si}$ der mit SIMS (Sekundärionen-Massenspektrometrie) gemessenen Signale für die Intensität I von $SiO_2$ und Si im Bereich von 40 bis 3.

Das Intensitätsverhältnis $I_{SiH/Si}$ der mit SIMS (Sekundärionen-Massenspektrometrie) gemessenen Signale für die Intensität I von SiH und Si beträgt gemäß der Erfindung 15 bis 10.

Im Rahmen der Erfindung haben sich Passivierungsschichten als besonders stabil erwiesen, welche $Si_xO_zC_y$ umfassen. Dabei liegt x im Bereich von 18 bis 23. Bevorzugt wird eine Passivierungsschicht mit x gleich 21. Der Wert für y liegt im Bereich von 41 bis 58, bevorzugt im Bereich von 44 bis 55. Besonders bevorzugt ist y gleich 48. Der Wert für z liegt im Bereich von 23 bis 38, bevorzugt im Bereich von 25 bis 36, besonders bevorzugt ist z gleich 31. Die Summe von x, y und z ergibt 100.

Die Zahlenangaben für x, y und z sind in at-% wiedergegeben und wurden durch MCs+-Analysen bestimmt. Diese Analysemethode ist eine Technik für quantitative SIMS-Untersuchungen, wobei MCs+-Sekundärionen detektiert werden, die nach Beschuß des zu testenden Materials mit Cäsium-Primärionen entstehen. M steht dabei für das nachzuweisende Element. Die MCs+-Ionen bilden sich durch Kombination aus gesputterten neutralen M-Ionen und implantierten und wieder gesputterten Cs+-Ionen.

Die Erfindung ermöglicht insbesondere durch die Anwendung eines PICVD-Verfahrens das Aufbringen von Passivierungsschichten auch auf temperatursensitiven Substraten beziehungsweise Barrierebeschichtungen. So wird durch die Erfindung vorzugsweise ein Verbundmaterial bereit gestellt mit einem Substrat, welches zumindest einen Kunststoff, insbesondere zumindest einen Polyester und/oder zumindest ein Polyolefin und/oder zumindest einen temperatursensitiven kompostierbaren Kunststoff umfaßt. Beispielsweise kann das Substrat PE und/oder PP und/oder PET und/oder PEN und/oder LDPE und/oder HDPE und/oder PC und/oder COC/COP und/oder PLA umfassen. Das Substrat kann im Rahmen der Erfindung aber auch Papier und/oder zumindest einen Verbundwerkstoff umfassen. Generell können als Substrate Materialien mit $T_G$ unterhalb von 250°C verwendet werden.

Vorzugsweise wird die Passivierungsschicht gemäß dem erfindungsgemäßen Verbundmaterial angewendet, um eine Barrierebeschichtung in einem Behälter wie zum Beispiel eine Flasche oder einen Kunststoffbecher, wie er insbesondere in Getränkeautomaten bereitgestellt wird, gegen Angriffe zu schützen, die bei herkömmlichen Behältern durch den Kontakt mit einem in dem Behälter abgefüllten Flüssigkeit auf das Behältermaterial ausgeübt werden.

Die Erfindung stellt somit einen Behälter bereit, welcher einen Hohlkörper umfaßt, wobei der Hohlkörper einen Innenraum definiert und zumindest eine Öffnung aufweist, welche den Innenraum mit der Umgebung des Hohlkörpers verbindet. Die Öffnung kann beipielsweise im Flaschenhals einer Getränkeflasche oder in der oben offenen Seite eines Bechers bestehen. Der Hohlkörper umfaßt zumindest ein Verbundmaterial, wie es oben beschrieben wurde. Vorzugsweise ist die Passivierungsschicht dem Innenraum des Hohlkörpers zugewandt ist.

Zum Herstellen eines erfindungsgemäßen Verbundmaterials stellt die Erfindung des Weiteren ein Verfahren mit folgenden Schritten bereit:

a) Bereitstellen von wenigstens einem Substrat in einem Behandlungsraum, wobei das Substrat eine Barriereschicht aufweist,

b) Evakuieren des Behandlungsraums,

c) Erzeugen einer Passivierungsschicht durch Plasmaimpuls-induziertes CVD-Beschichten (PICVD-Beschichten).

Das Substrat kann im Rahmen der Erfindung beispielsweise in Form eines Behälters, welcher innen eine Barrierebeschichtung aufweist bereitgestellt werden. In der DE 102 53 512.4-45 der Anmelderin wird das Beschichten derartiger Behälter mit PICVD beschrieben. Der Inhalt dieser Schrift zum Durchführen eines PICVD-Verfahrens zur Innenbeschichtung von Behältern wird durch Bezugnahme in die vorliegende Anmeldung aufgenommen.

Vorteilhafterweise wird beim Erzeugen der Passivierungsschicht als Precursor im Wesentlichen HMDSO verwendet, um eine im wesentlichen unpolare organische Deckschicht auf der Barriereschicht zu erzielen.

Eine Passivierungsschicht kann zusätzlich oder alternativ auch erzeugt werden, indem der vom Substrat abgewandte Bereich der Barriereschicht in seiner Struktur verdichtet wird. Dazu sieht die Erfindung vor, daß beim Erzeugen der Passivierungsschicht der Behandlungsraum geerdet wird und ein HF-Bias zwischen der Gaslanze und dem geerdeten Behandlungsraum angelegt wird. Dadurch werden die sich bei der Durchführung des PICVD-Verfahrens ablagernden Partikel derart von der Gaslanze weg und damit auf das Substrat, welches sich zwischen der Gaslanze und der Wand des Behandlungsraums befindet, zu bewegt, daß beim Auftreffen auf die auf dem Susbtrat vorhandene Barriereschicht diese infolge der "Einschläge" der sich abscheidenden Partikel verdichtet wird.

In einer bevorzugten Ausführungsform der Erfindung ist vorgesehen, daß beim Erzeugen der Passivierungsschicht schwere Ionen, insbesondere Edelgasionen wie beispielsweise Ar und/oder Xe, dem Precursorgas beigemischt werden, um die Passivierungsschicht zu verdichten.

Beim Erzeugen der Passivierungsschicht werden vorteilhafterweise Frequenzen im Bereich von MW, insbesondere 2,45 GHz, oder HF zum Anregen des Plasmas eingesetzt, da sich gezeigt hat, daß dann die Verdichtung des betreffenden Bereichs der Barriereschicht besonders wirkungsvoll ist.

Die Erfindung wird nachfolgend unter Bezugnahme auf die beigefügten Zeichnungen anhand von Ausführungsbeispielen näher erläutert. Dieselben Komponenten sind in allen Zeichnungen mit denselben Bezugszeichen versehen.

Es zeigen:

Figur 1     eine schematische Darstellung eines Längsschnitts durch ein Verbundmaterial gemäß einer ersten Ausführungsform der Erfindung,

Figur 2     eine schematische Darstellung eines Längsschnitts durch ein Verbundmaterial gemäß einer zweiten Ausführungsform der Erfindung,

Figur 3     eine schematische Darstellung eines Längsschnittes durch einen Behälter mit einem Verbundmaterial gemäß der zweiten Ausführungsform der Erfindung,

Figur 4     ein Diagramm, welches das Ergebnis einer ATR-Analyse von vier Passivierungsschichten gemäß der Erfindung angibt, welche bei unterschiedlicher Precursorkonzentration hergestellt wurden,

Figur 5     ein Diagramm mit dem Ergebnis der ATR-Messung für die bei einer Precursorkonzentration von 45 % HMDSO hergestellte Passivierungsschicht,

Figur 6     zwei SIMS-Intensitäts-Sputterzeitprofile eines erfindungsgemäßen Verbundmaterials,

Figur 7     eine schematische Darstellung zur Illustration der Bestimmung von Empfindlichkeitsfaktoren zur Auswertung der Analysen; Zusammensetzung der Schichten (oben) und relative SIMS-Empfindlichkeitsfaktoren (unten),

Figur 8     eine schematische Darstellung zur Illustration der Durchführung des erfindungsgemäßen Verfahrens nach einer ersten Ausführungsform,

Figur 9     eine schematische Darstellung zur Illustration des erfindungsgemäßen Verfahrens nach einer zweiten Ausführungsform und

Figur 10     eine schematische Darstellung zur Durchführung des erfindungsgemäßen Verfahrens nach einer dritten Ausführungsform.

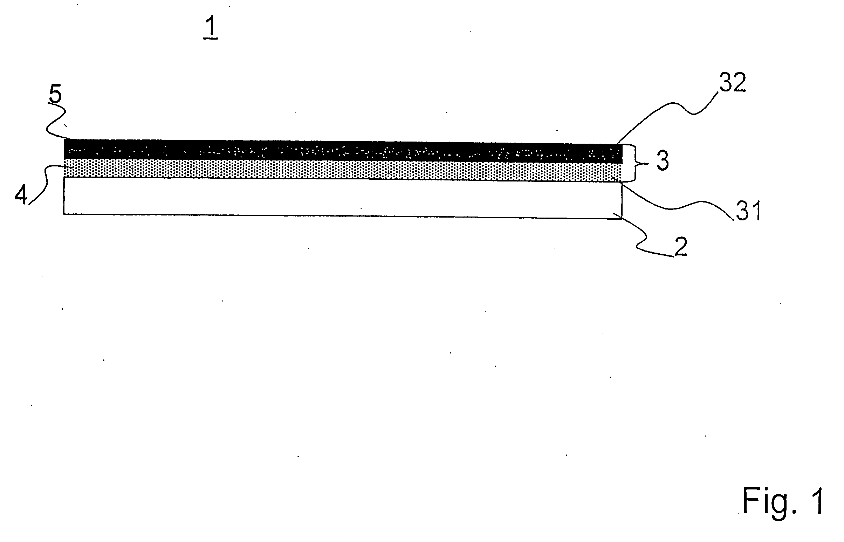

Gemäß der Darstellung in Figur 1 umfaßt das Verbundmaterial 1 ein Substrat 2 und eine Beschichtung 3. Die Beschichtung 3 hat einen ersten Bereich 31, welcher dem Substrat 2 zugewandt ist und einen zweiten Bereich 32, welcher dem Substrat 2 abgewandt ist. Die Beschichtung 3 umfaßt eine Barriereschicht 4 und eine Passivierungsschicht 5 als top coat. Die Barriereschicht hemmt den Stoffaustausch zwischen der Umgebung des Substrats 2, welche bei der Darstellung in Figur 1 dem Bereich entspricht, der sich unten an das Substrat 2 anschließt, und einem mit dem Verbundmaterial 1 in Kontakt stehendem Medium, welches entsprechend der Darstellung in Figur 1 oben in Kontakt mit der Passivierungsschicht 5 positioniert wäre. Die Passivierungsschicht 5 schützt die Barriereschicht 4 vor Angriffen durch dieses Medium.

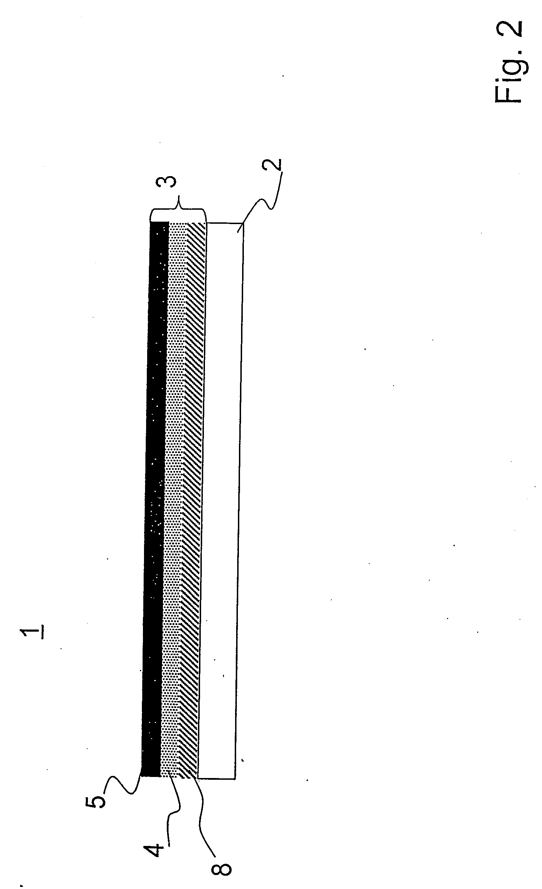

Gemäß einer weiteren Ausführungsform der Erfindung kann die Beschichtung 3 neben der Barriereschicht 4 und der Passivierungsschicht 5 zur Verbesserung der Haftung der Beschichtung auf dem Substrat 2 eine Haftvermittlerschicht 8 umfassen. Ein derartiges Verbundmaterial ist in Figur 2 dargestellt. Solche Verbundmaterialien eignen sich besonders zur Innenbeschichtung von Behältern.

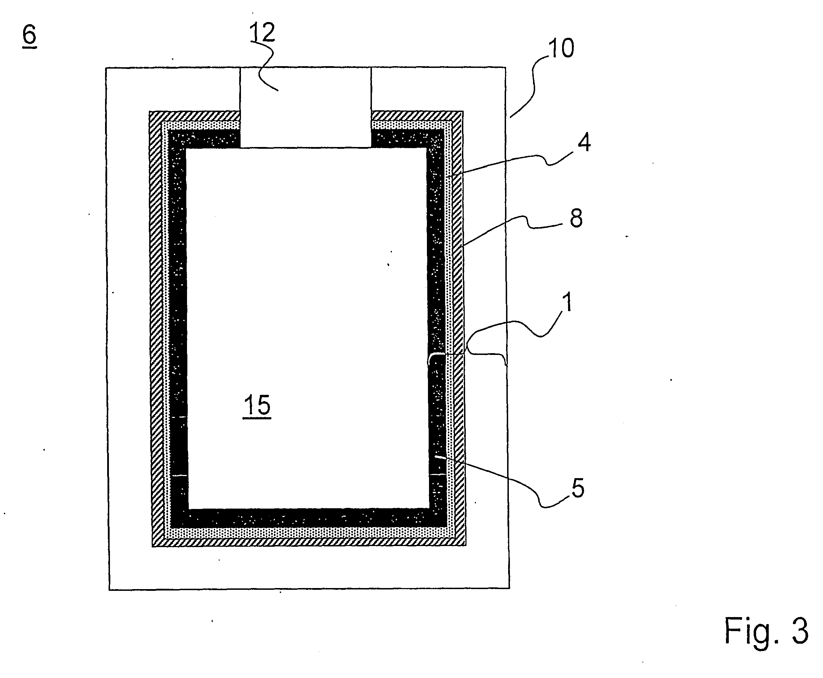

Ein solcher Behälter 6 ist in Figur 3 gezeigt. Der Behälter 6 umfaßt einen Hohlkörper 10, der einen Innenraum 15 hat. Durch die Öffnung 12 kann ein Medium, wie beispielsweise ein Getränk, in den Innenraum gefüllt bzw. aus dem Innenraum 15 entnommen werden. Der Innenraum 15 ist durch die Passivierungsschicht 5 von der Barriereschicht 4 getrennt. Zur Verbesserung der Haftung des Schichtsystems ist eine Haftungsvermittlerschicht 8 zwischen der Barriereschicht 4 und dem Substrat aufgebracht.

Für die in den Figuren 1 bis 3 dargestellten Ausführungsbeispiele wurden die betreffenden Beschichtungen mit SIMS analysiert. Zudem wurden ATR-Messungen durchgeführt. Beim Herstellen der Schichten wurde für die Passivierungsschicht der Precursor HMDSO und für die Barriereschicht der Precursor HMDSN verwendet. Für die Passivierungsschicht wurde die Konzentration des Precursors im Gasgemisch von 17 % über 45 % und 73 % bis hin zu 100 % variiert. Für HMDSN wurde eine Variation von 1,2 % über 45 % zu 100 % durchgeführt.

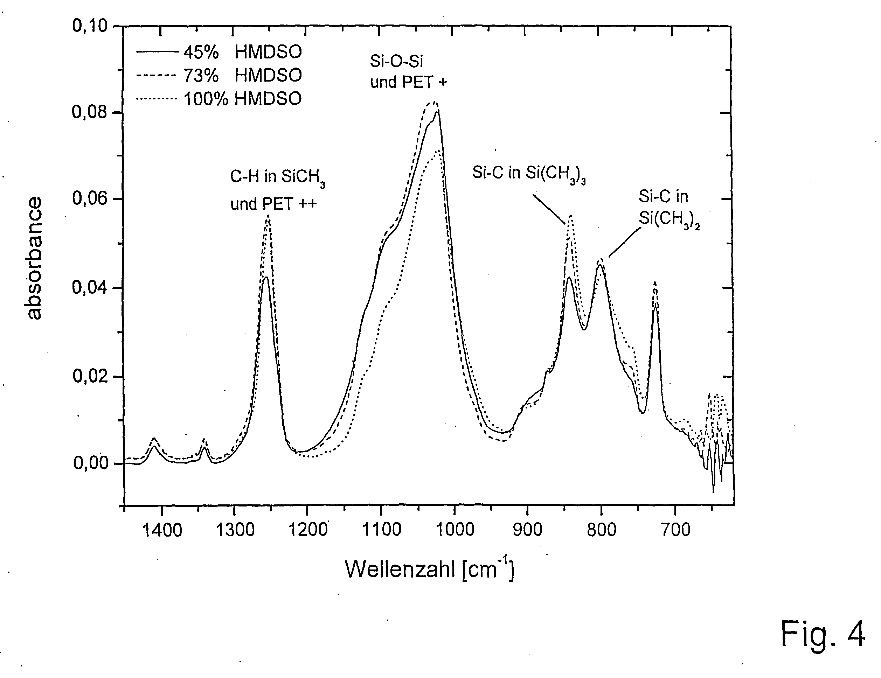

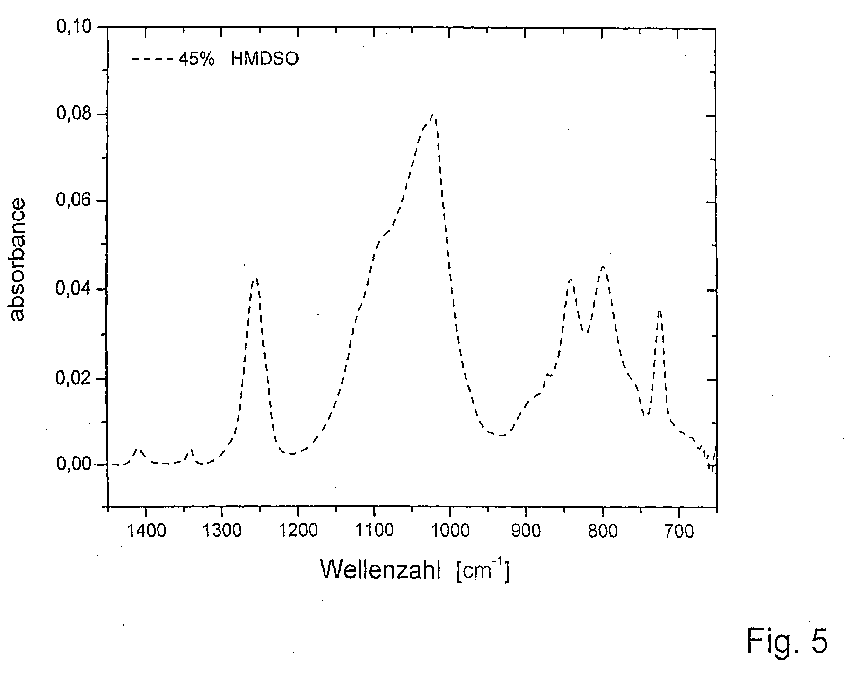

In Figur 4 ist das ATR-Spektrum für Passivierungsschichten mit variabler Precursorkonzentration bei ihrer Herstellung dargestellt. Bestimmte Bindungstypen lassen sich bei charakteristischen Wellenzahlen nachweisen. In Figur 5 ist das ATR-Spektrum für eine Passivierungsschicht, welche mit 45 % HMDSO als Precursor im Gasgemisch für die Beschichtung hergestellt wurde, einzeln dargestellt. Aus den bei den Wellenzahlen von 840 cm$^{-1}$, 799 cm$^{-1}$, 1253 cm$^{-1}$, 1000 cm$^{-1}$ und 1100 cm$^{-1}$ ermittelten Werten für die Intensität wurden aus den ATR-Messungen charakteristische Kennzahlen für den organischen Anteil und für die Vernetzung innerhalb der Schichten als O- und N-Parameter bestimmt. Die Ergebnisse sind in Tabelle 1 zusammengestellt.

Die Precursorkonzentration wurde in den Experimenten verändert und von geringen Werten auf 100 % gesteigert. Welche Werte für die Precursorkonzentration optimale Ergebnisse für N- beziehungsweise O-Parameter liefern, hängt von der jeweils benutzten PICVD-Anlage ab. Daher sind bei einem Wechsel der Anlage entsprechende Optimierungen durchzuführen. Im vorliegenden Fall wurde die HMDSO-Konzentration von 17 % über 45 % und 73 % auf 100 % gesteigert und die HMDSN-Konzentration von 1,2 % über 45 % auf 100 %.

Tabelle 1: N- und O-Parameter für Schichten auf HMDSO- und HMDSN-Basis.

| HMDSO | N-Parameter | O-Parameter |
|---|---|---|
| | 0,88 ± 10 % | überlagert von PET |
| ↓ | 0,92 ± 10 % | 0,5 ± 10 % |
| | 1,19 ± 10 % | 0,7 ± 10 % |
| 100 % | 1,44 ± 10 % | 0,8 ± 10 % |
| HNDSN | N-Parameter | O-Parameter |
| ↓ | nicht auswertbar (PET) | nicht auswertbar |
| | 0, 9 ± 20 % | 0,9 ± 20 % |
| 100 % | 1,5 ± 20 % | 3,3 ± 20 % |

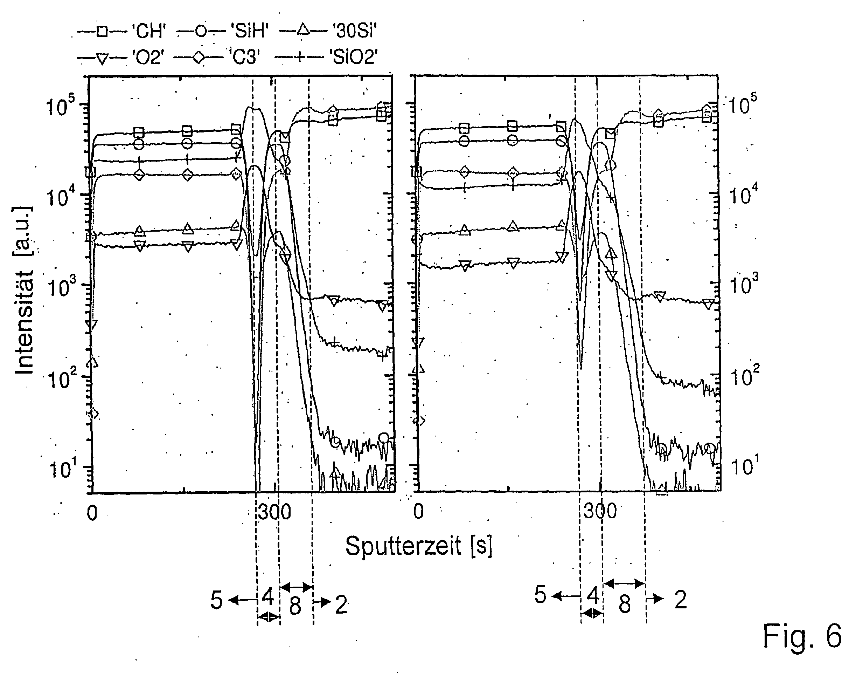

In Figur 6 sind SIMS-Intensitäts-Sputterzeitprofile eines erfindungsgemäßen Verbundmaterials aufgetragen. Das in Figur 6 auf der linken Seite wiedergegebene Diagramm wurde an einem Verbundmaterial gemessen, welches eine Passivierungsschicht 5 hat, die bei einer Precursorkonzentration von 45 % HMDSO hergestellt wurde, und welche eine Barriereschicht 4 aufweist, die bei einer Precursorkonzentration von 1,2 % HMDSN abgeschieden wurde, sowie eine Haftvermittlerschicht 8 auf einem PET-Substrat 2 aufweist, die bei einer Precursorkonzentration von 17 % HMDSO hergestellt wurde. Für das Verbundmaterial, dessen SIMS-Sputterzeitprofil im rechten Diagramm in Figur 6 dargestellt ist, betrug die Precursorkonzentration beim Herstellen der Passivierungsschicht 73 % HMDSO. Die übrigen Parameter sind unverändert.

Die Auswertung derartiger SIMS-Analysen ergab die in Tabelle 2 zusammengefaßten Intensitätsverhältnisse. Zur Variation der Precursorkonzentration gilt auch hier das im Zusammenhang mit Tabelle 1 gesagte.

Tabelle 2: SIMS-Intensitätsverhältnisse für Schichten auf HMDSO- und HMDSN-Basis.

| HMDSO | $C_3$/Si | $SiO_2$/Si | SiH/Si | |
|---|---|---|---|---|
| ↓ | 2,8 | 43 | 14 | |
| | 4,1 | 9,2 | 12 | |
| | 5,2 | 5,3 | 11 | |
| 100 % | 6,7 | 3,7 | 11 | |
| HMDSN | $C_3$/Si | $SiO_2$/Si | SiH/Si | SiN/Si |
| ↓ | 0,01 | 35,4 | 1,4 | 0,04 |
| | 3,2 | 7,2 | 11 | 6,6 |

(fortgesetzt)

| HMDSO | $C_3/Si$ | $SiO_2/Si$ | SiH/Si | |
|---|---|---|---|---|
| 100 % | 5,2 | 0,12 | 7,4 | 7,1 |

Mit Angaben der Form "$C_3/Si$" wird das Verhältnis der Intensität des mit SIMS gemessenen Signals für $C_3$ zur Intensität des mit SIMS gemessenen Signals für Si angegeben. Die HMDSO- beziehungsweise HMDSN-Konzentration gibt die Konzentration im Beschichtungsgas in Vol.-% an, wobei der Rest Sauerstoff ist, die bei der Herstellung der analysierten Schicht eingesetzt wurde.

Mit zunehmender HMDSO- und HMDSN-Konzentration steigt der organische Charakter der Schicht an, wie das SIMS-$C_3/Si$-Verhältnis und der O-Parameter aus der ATR-Analyse belegen. Auf der Basis von MCs+-Tiefenprofilanalysen erfolgte eine Charakterisierung der Zusammensetzung von $Si_xO_zC_y$-Schichten, welche im PICVD-Verfahren unter Verwendung von unterschiedlichen Precursorkonzentrationen auf PET abgeschieden wurden.

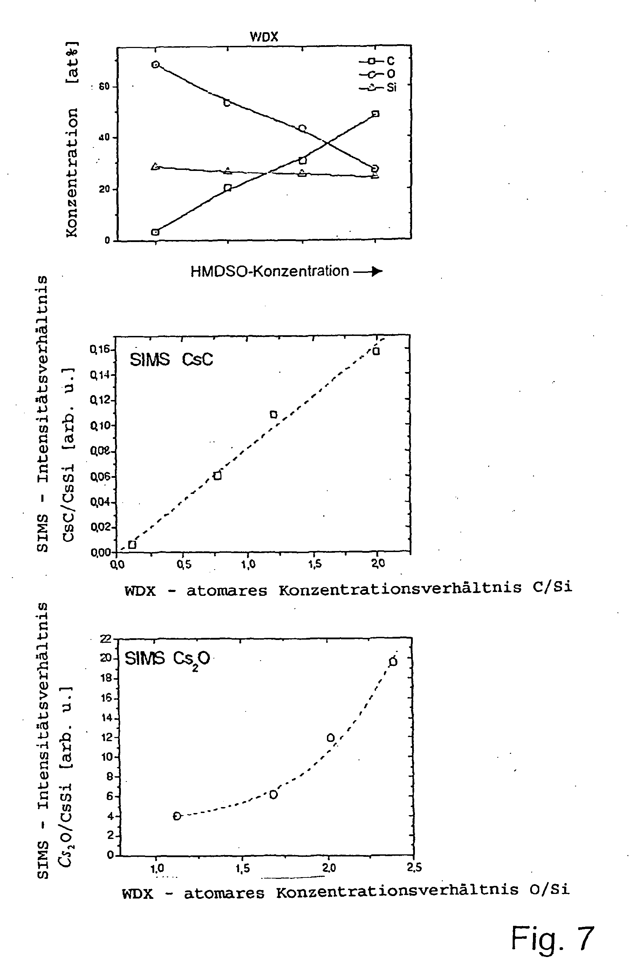

Für die Auswertung lagen relative Empfindlichkeitsfaktoren von Analysen matrixähnlicher Proben vor. Um die Zusammensetzung der Schichten quantitativ zu bestimmen, erfolgten WDX-Analysen bei einer Anregungsenergie von 5 keV (Signal nur aus der Schicht). Unter Vernachlässigung des Wasserstoffgehaltes, der methodenbedingt nicht zu erfassen ist, wurde für die Auswertung der C-Astimex-Standard (100% C) und Herasil (= 100% SiO2) verwendet. Die zugehörigen Ergebnisse sind in Figur 7 (oben) graphisch dargestellt.

Aufgrund der Informationstiefe sind quantitative WDX- oder EDX-Analysen auf Schichten mit Mindestdicken von einigen 100 nm beschränkt. Für dünnere Schichten bietet sich die semiquantitative MCs+-Variante der SIMS an. In Figur 7 sind die Intensitätsverhältnisse CsC+/CsSi+ und $Cs_2O+$/CsSi+ aus entsprechenden Tiefenprofilierungen gegen die Konzentrationsverhältnisse aufgetragen (aus WDX-Analyse).

Für CsC+/CsSi+ ergibt sich eine lineare Abhängigkeit, das heißt für die $SiO_xC_y$-Schichten kann ein relativer Empfindlichkeitsfaktor bestimmt werden, der eine Quantifizierung des C/Si-Gehalts erlaubt. Bei der Ermittlung des O/Si-Anteils ist hingegen die nichtlineare Abhängigkeit der MCs+-Intensitäten von der Zusammensetzung zu berücksichtigen (siehe Figur 7).

## Tabelle 3: Ergebnisse der MCs+-Messungen

| HMDSO-Konzentration [Vol.-%] | Int. CsC/CSi | Int. $Cs_2O$/CsSi | Konzentration [at.-% ± 5 at.-%] | | |
|---|---|---|---|---|---|
| | | | C (y) | Si (x) | O (z) |
| ↓ | 0,18 | 7,9 | 44 | 20 | 36 |
| | 0,19 | 5,3 | 48 | 21 | 31 |
| | 0,21 | 5,0 | 52 | 20 | 28 |
| 100 | 0,23 | 4,6 | 55 | 20 | 25 |

Die Abkürzung "Int" steht in Tabelle 3 für Intensität, mit "Int. CsC/Csi" ist das Intensitätsverhältnis des Signals für CsC zu dem Signal für CSi gemeint, mit "Int. $Cs_2O$/CsSi" entsprechend das Intensitätsverhältnis des Signals für $Cs_2O$ zu dem Signal für CsSi. Die HMDSO-Konzentration gibt die Konzentration im Beschichtungsgas an, wobei der Rest Sauerstoff ist, die bei der Herstellung der analysierten Passivierungsschicht eingesetzt wurde. Zur Variation der Precursorkonzentration gilt auch hier das im Zusammenhang mit Tabelle 1 gesagte.

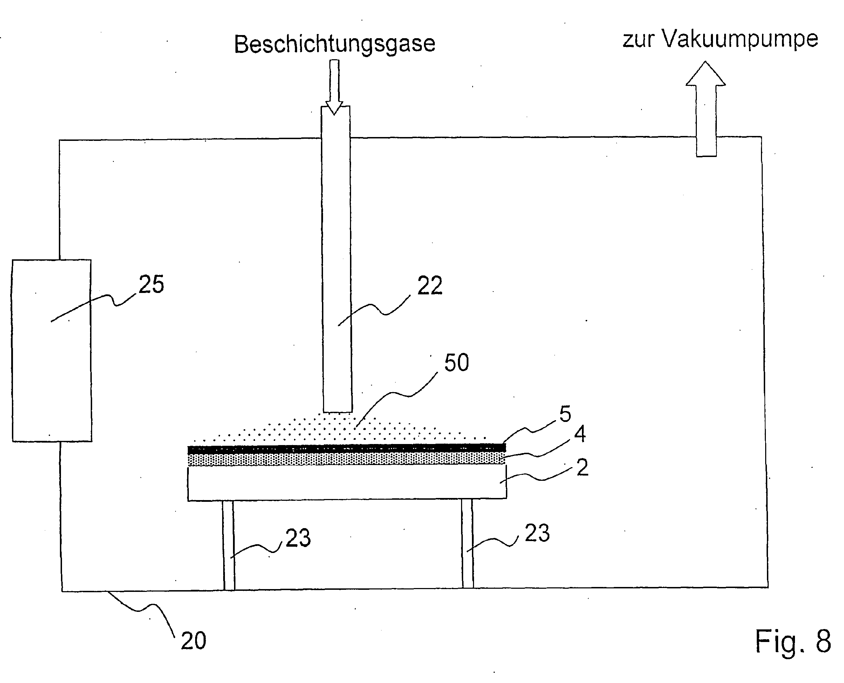

In den Figuren 8 bis 10 wird die Herstellung eines Verbundmaterials mit einer oben näher beschriebenen Passivierungsschicht illustriert. Das Substrat 2, das eine Barriereschicht 4 aufweist, wird in einem Behandlungsraum 20 bereitgestellt. In den Figuren ist dies durch die Halterung des Substrats 2 auf Substrathaltern 23 angedeutet. Mit Hilfe einer Vakuumpumpe (nicht dargestellt) wird der Behandlungsraum evakuiert. Die Beschichtungsgase werden über eine Gaslanze 22 in den Behandlungsraum geführt. Dort wird mit Hilfe einer Plasmaquelle 25 ein Plasma gezündet. Gemäß der Erfindung werden dabei Teilchen 50 auf der Oberfläche der Barriereschicht 4 unter Ausbildung einer Passivierungsschicht 5 abgeschieden (siehe Figur 8).

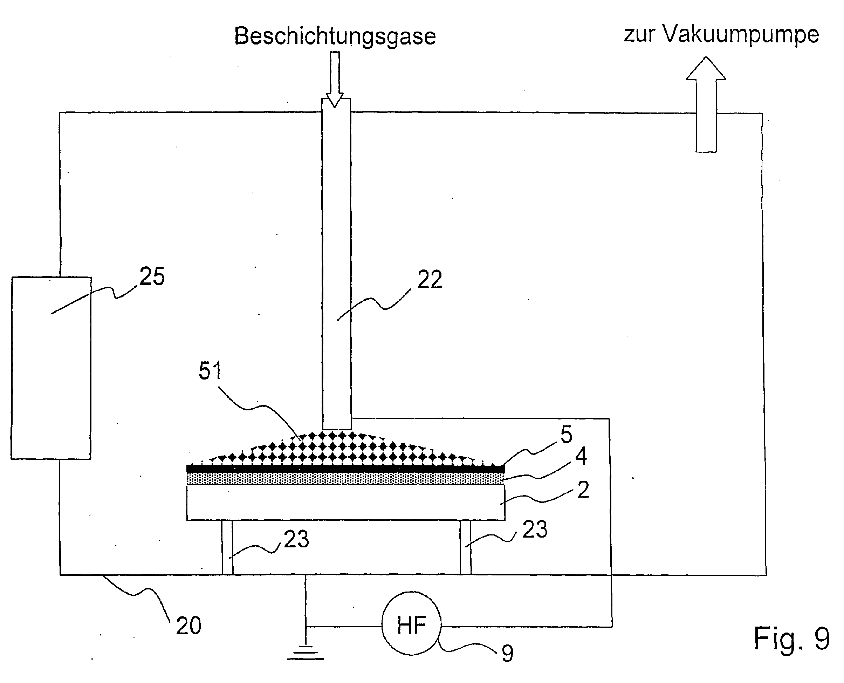

In einer weiteren Ausführungsform des Verfahrens, die in Figur 9 gezeigt ist, wird zwischen dem geerdeten. Behandlungsraum 20 und der Gaslanze 22 ein HF-Bias 9 angelegt. Den Beschichtungsgasen 51 sind schwere Ionen wie zum Beispiel Edelgasionen beigemischt.

Die Ionen werden in der Randschicht des elektrischen Feldes zwischen Plasma und Behälter 20 beschleunigt und treffen mit hoher Energie auf die Oberfläche des entstehenden Verbundmaterials beziehungsweise auf die Beschichtung auf. Dies führt bei ausreichender Ionenenergie zu einer Verdichtung der Beschichtung und einer Reduktion von Störungen in der Struktur wie "pinholes". Die Energie des HF-Bias wird dabei so gewählt, daß es nicht zu einem zu starken Aufheizen und/oder gar zu einem Absputtern der Beschichtung kommt.

Ein besonderer Vorteil dieses Verfahrens ist die verbesserte Haftung der Beschichtung auf Kunststoffsubstraten. Als Anregungsfrequenz für das Plasma im Behandlungsraum können zudem Frequenzen eingesetzt werden, die eine höhere Plasmarandschichtspannung im Vergleich zu einer Mikrowellenanregung erzeugen.

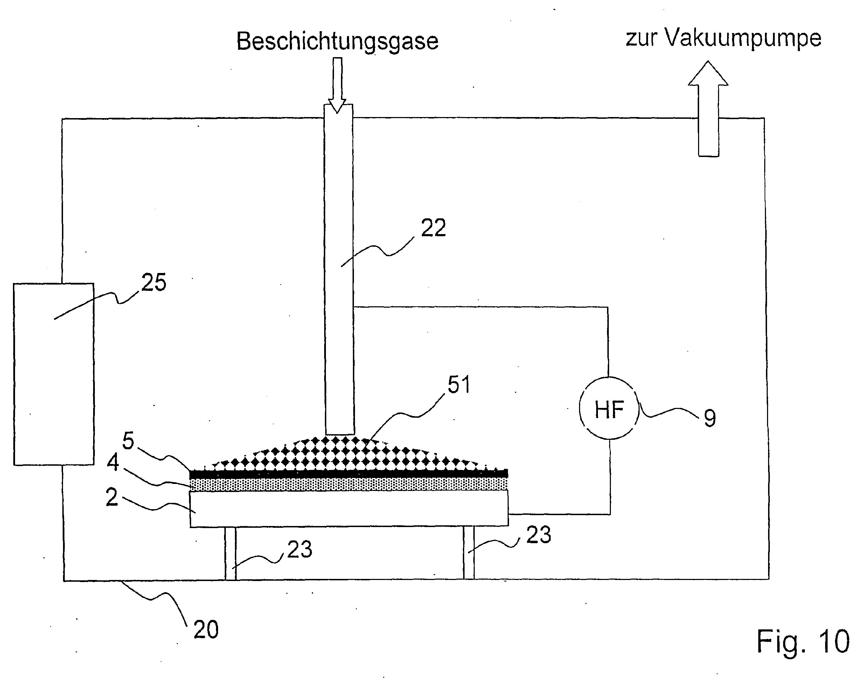

Gemäß einer weiteren Ausführungsform des Verfahrens, welche in Figur 10 dargestellt ist, kann der HF-Bias auch zwischen dem Substrat und der Gaslanze angelegt werden. Die Substrathalter 23 sind dabei isoliert gegenüber dem Substrat. Dann ist das elektrische Feld auf den Bereich konzentriert, in welchem die Bildung der Passivierungsschicht erfolgt, so daß die Abscheidung der die Schicht bildenden Teilchen und der beigemischten schweren Ionen besonders effizient ist.

Es ist dem Fachmann ersichtlich, dass die Erfindung nicht auf die vorstehend beschriebenen Ausführungsbeispiele beschränkt ist, sondern vielmehr in vielfältiger Weise variiert werden kann. Insbesondere können die Merkmale der einzelnen Ausführungsbeispiele auch miteinander kombiniert werden.

Bezugszeichenliste

1   Verbundmaterial
2   Substrat
3   Beschichtung
31   erster Bereich der Beschichtung
32   zweiter Bereich der Beschichtung
4   Barriereschicht
5   Passivierungsschicht -
50   Teilchen, die als PICVD-Beschichtung abgeschieden werden
51   Teilchen, die als PICVD-Beschichtung abgeschieden werden und schwere Ionen umfassen
6   Behälter
8   Haftvermittlerschicht
9   HF-Bias, Spannungsquelle
10   Hohlkörper
15   Innenraum des Hohlkörpers
20   Behandlungsraum
22   Gaslanze
23   Substrathalterung im Behandlungsraum
25   Plasmaquelle

**Patentansprüche**

1. Verbundmaterial (1) umfassend ein Substrat (2) und eine Beschichtung (3) auf dem Substrat (2), wobei die Beschichtung (3) zumindest einen dem Substrat (2) zugewandten ersten Bereich (31) und zumindest einen vom Substrat abgewandten zweiten Bereich (32) aufweist, wobei der erste Bereich eine Barriereschicht (4) umfasst die silizium und Sauerstoff enthält, **dadurch gekennzeichnet, dass** der zweite Bereich eine Passivierungsschicht (5) mit einer Beständigkeit gegenüber von pH-Werten im Bereich von pH 5,0 bis pH 7,5 umfasst, wobei die Passivierungsschicht (5) Silizium, Sauerstoff und Kohlenstoff enthält, dass sowohl die Barriereschicht (4) als auch die Passivierungsschicht (5) durch ein CVD-Verfahren abgeschieden sind und dass die Passivierungsschicht (5) einen O-Parameter

$$\text{mit O - Parameter} = \frac{\text{Intensität bei } 1253 \text{ cm}^{-1}}{\text{Intensität bei } (1000 \text{ cm}^{-1} \text{ bis } 1100 \text{ cm}^{-1})}$$

gemessen mit ATR (attenuated total reflection) im Bereich von 0,4 bis 0,9 aufweist und/oder, daß die Passivierungsschicht (5) einen N-Parameter

$$\text{mit N - Parameter} = \frac{\text{Intensität bei } 840 \text{ cm}^{-1}}{\text{Intensität bei } 799 \text{ cm}^{-1}}$$

gemessen mit ATR (attenuated total reflection) im Bereich von 0,7 bis 1,6 aufweist und dass die Passivierungsschicht (5) $Si_xO_zC_y$ umfaßt mit x im Bereich von 18 bis 23 und y im Bereich von 41 bis 58 und z im Bereich von 23 bis 38.

2. Verbundmaterial (1) nach einem der vorangegangenen Ansprüche, **dadurch gekennzeichnet, dass** das Substrat (2) zumindest einen Kunststoff und/oder zumindest ein Polyolefin und/oder zumindest einen temperatursensitiven kompostierbaren Kunststoff umfasst.

3. Verbundmaterial (1) nach einem der vorangegangenen Ansprüche, **dadurch gekennzeichnet, dass** das Substrat (2) PE und/oder PP und/oder PET und/oder PEN und/oder LDPE und/oder HDPE und/oder PC und/oder COC/COP und/oder PLA umfasst.

4. Verbundmaterial (1) nach einem der vorangegangenen Ansprüche, **dadurch gekennzeichnet, dass** das Substrat (2) Papier und/oder zumindest einen Verbundwerkstoff umfaßt.

5. Behälter (6) umfassend einen Hohlkörper (10), welcher einen Innenraum (15) definiert und zumindest eine Öffnung (12) aufweist, welche den Innenraum (15) mit der Umgebung des Hohlkörpers (10) verbindet, wobei der Hohlkörper zumindest ein Verbundmaterial (1) nach einem der Ansprüche 1 bis 4 umfaßt.

6. Behälter (6) nach Anspruch 5, **dadurch gekennzeichnet, dass** die Passivierungsschicht (5) dem Innenraum (15) des Hohlkörpers (10) zugewandt ist.

7. Verfahren zum Herstellen eines Verbundmaterials (1) nach einem der Ansprüche 1 bis 4, mit folgenden Schritten:

   a) Bereitstellen von wenigstens einem Substrat (2), welches eine Barriereschicht (4) aufweist, in einem Behandlungsraum (20),
   b) Evakuieren des Behandlungsraums (20),
   c) Erzeugen einer Passivierungsschicht (5) durch Plasmaimpuls-induziertes CVD-Beschichten.

8. Verfahren nach Anspruch 7, **dadurch gekennzeichnet, dass** beim Erzeugen der Passivierungsschicht (5) als Precursor im wesentlichen HMDSO verwendet wird.

9. Verfahren nach einem der Ansprüche 7 oder 8, **dadurch gekennzeichnet, dass** beim Erzeugen der Passivierungsschicht (5) der Behandlungsraum (20) geerdet wird und ein HF-Bias (9) zwischen der Gaslanze (22) und dem geerdeten Behandlungsraum (20) angelegt wird.

10. verfahren nach Anspruch 9, **dadurch gekennzeichnet, dass** beim Erzeugen der Passivierungsschicht (5) schwere Ionen, insbesondere Edelgasionen, dem Precursorgas beigemischt werden.

11. Verfahren nach einem der Ansprüche 7 bis 10, **dadurch gekennzeichnet, dass** beim Erzeugen der Passivierungsschicht (5) Frequenzen im Bereich von MW oder HF zum Anregen des Plasmas eingesetzt werden.

**Claims**

1. Composite material (1) comprising a substrate (2) and a coating (3) on the substrate (2), the coating (3) having at least a first region (31) facing the substrate (2) and at least a second region (32) remote from the substrate, the first region comprising a barrier layer (4) containing silicon and oxygen, **characterised in that** the second region comprises a passivation layer (5) with resistance towards pH values in the range from pH 5.0 to pH 7.5, the passivation layer (5) containing silicon, oxygen and carbon, **in that** both the barrier layer (4) and the passivation layer (5) are deposited by a CVD process, and **in that** the passivation layer (5) has an O-parameter,

$$\text{where O-parameter} = \frac{\text{Intensity at 1253 cm}^{-1}}{\text{Intensity at (1000 cm}^{-1} \text{ to 1100 cm}^{-1})},$$

measured by ATR (attenuated total reflection), in the range from 0.4 to 0.9 and/or **in that** the passivation layer (5) has an N-parameter,

$$\text{where N-parameter} = \frac{\text{Intensity at 840 cm}^{-1}}{\text{Intensity at 799 cm}^{-1}},$$

measured by ATR (attenuated total reflection), in the range from 0.7 to 1.6, and **in that** the passivation layer (5) comprises SixOzCy, where x is in the range from 18 to 23 and y is in the range from 41 to 58 and z is in the range from 23 to 38.

2. Composite material (1) according to any one of the preceding claims, **characterised in that** the substrate (2) comprises at least one plastics material and/or at least one polyolefin and/or at least one temperature-sensitive compostable plastics material.

3. Composite material (1) according to any one of the preceding claims, **characterised in that** the substrate (2) comprises PE and/or PP and/or PET and/or PEN and/or LDPE and/or HDPE and/or PC and/or COC/COP and/or FLA.

4. Composite material (1) according to any one of the preceding claims, **characterised in that** the substrate (2) comprises paper and/or at least one composite material.

5. Container (6) comprising a hollow body (10) which defines an internal space (15) and has at least one opening (12) which connects the internal space (15) with the surrounding area of the hollow body (10), wherein the hollow body comprises at least one composite material (1) according to any one of claims 1 to 4.

6. Container (6) according to claim 5, **characterised in that** the passivation layer (5) faces the internal space (15) of the hollow body (10).

7. Process for the production of a composite material (1) according to any one of claims 1 to 4, comprising the following steps:

   a) provision of at least one substrate (2), which has a barrier layer (4), in a treatment chamber (20),
   b) evacuation of the treatment chamber (20),
   c) production of a passivation layer (5) by plasma-pulse-induced CVD coating.

8. Process according to claim 7, **characterised in that**, on production of the passivation layer (5), substantially HMDSO is used as precursor.

9. Process according to either claim 7 or claim 8, **characterised in that**, on production of the passivation layer (5), the treatment chamber (20) is earthed and an HF bias (9) is applied between the gas lance (22) and the earthed treatment chamber (20).

**10.** Process according to claim 9, **characterised in that**, on production of the passivation layer (5), heavy ions, in particular noble gas ions, are mixed with the precursor gas.

**11.** Process according to any one of claims 7 to 10, **characterised in that**, on production of the passivation layer (5), frequencies in the range of MW or HF are used to excite the plasma.

**Revendications**

**1.** Matériau composite, qui comprend un substrat (2) et un revêtement (3) sur le substrat (2), sachant que le revêtement (3) présente au moins une première zone (31), orientée vers le substrat (2), et au moins une deuxième zone (32), opposée au substrat (2), la première zone comprenant une couche barrière (4) qui contient du silicium et de l'oxygène, **caractérisé en ce que** la deuxième zone est une couche de passivation (5), qui présente une résistance aux valeurs pH, situées dans un domaine de pH 5,0 à pH 7,5, sachant que la couche de passivation (5) contient du silicium, de l'oxygène et du carbone, que la couche barrière (4), ainsi que la couche de passivation (5) sont déposées selon un procédé CVD et que la couche de passivation (5) présente un paramètre

$$\text{avec O - Paramètre} = \frac{\text{Intensité à } 1253\ \text{cm}^{-1}}{\text{Intensité à } 1000\ \text{cm}^{-1} \text{ jusqu'à } 1100\ \text{cm}^{-1}}$$

mesuré par ATR (attenuated total reflection), dans une plage de 0,4 à 0,9, et ou que la couche de passivation (5) présente un N - paramètre

$$\text{avec N - Paramètre} = \frac{\text{Intensité à } 840\ \text{cm}^{-1}}{\text{Intensité à } 788\ \text{cm}^{-1}}$$

mesuré par ATR (attenuated total reflection), dans une plage de 0,7 à 1,6, et que la couche de passivation (5) comprend du SixOzCy avec x dans la plage de 18 à 23 et y dans la plage de 41 à 58 et z dans la plage de 23 à 38.

**2.** Matériau composite (1) selon la revendication 1, **caractérisé en ce que** le substrat (2) comprend au moins une matière synthétique et / ou au moins un polyoléfine et / ou au moins une matière synthétique sensible à la température, pouvant être compostée.

**3.** Matériau composite selon l'une des revendications précédentes, **caractérisé en ce que** le substrat (2) comprend du PE et / ou du PP et / ou du PEN et / ou du LDPE et / ou du HDPE et / Ou du PC et / ou du COC / COP et / ou du PLA.

**4.** Matériau composite selon l'une des revendications précédentes, **caractérisé en ce que** le substrat (2) comprend du papier et / ou au moins un matériau composite.

**5.** Récipient (6) comprenant un corps creux (10), qui définit une chambre intérieure (15) et est doté d'au moins une ouverture (12), qui relie la chambre intérieure (15) à l'environnement du corps creux (10), sachant que le corps creux (10) comprend au moins un matériau composite (1) selon l'une des revendications 1 à 4.

**6.** Récipient selon la revendication 5, **caractérisé en ce que** la couche de passivation (5) est orientée vers la chambre intérieure (15) du corps creux (10).

**7.** Procédé de fabrication d'un matériau composite (1) selon l'une des revendications 1 à 4, qui comprend les étapes suivantes :

a) mise à disposition, dans une chambre de traitement (20), d'au moins un substrat (2), qui présente une couche barrière (4),
b) mise sous vide de la chambre de traitement (20),
c) réalisation d'une couche de passivation (5) par revêtement CVD assisté au plasma.

8.  Procédé selon la revendication 7, **caractérisé en ce que**, lors de la réalisation de la couche de passivation (5), on utilise essentiellement du HMDSO comme précurseur.

9.  Procédé selon l'une des revendications 7 et 8, **caractérisé en ce que**, lors de la réalisation de la couche de passivation (5), la chambre de traitement (20) est mise à la terre et qu'un HF-Bias (9) est aménagé entre la lance à gaz (22) et la chambre de traitement (20) mise à la terre.

10. Procédé selon la revendication 9, **caractérisé en ce que**, lors de la réalisation de la couche de passivation (5), des ions lourds, en particulier des ions de gaz rares, sont ajoutés au gaz précurseur.

11. Procédé selon l'une des revendications 7 à 10, **caractérisé en ce que**, lors de la réalisation de la couche de passivation (5), des fréquences MW ou HF sont mises en oeuvre pour l'excitation du plasma.

Fig. 1

EP 2 079 783 B1

Fig. 2

Fig. 3

EP 2 079 783 B1

Fig. 4

Fig. 5

EP 2 079 783 B1

Fig. 6

EP 2 079 783 B1

Fig. 7

Fig. 8

zur Vakuumpumpe

Beschichtungsgase

Fig. 9

Beschichtungsgase

zur Vakuumpumpe

22

25

51

HF 9

5

4

2

23

23

20

Fig. 10

EP 2 079 783 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 10314779 A1
- WO 0216484 A
- EP 1630250 A
- DE 10253512445